# EUROPÄISCHE PATENTSCHRIFT

(11) **EP 1 019 957 B1**
(45) Veröffentlichungstag und Bekanntmachung des Hinweises auf die Patenterteilung: **29.01.2003**
(21) Anmeldenummer: 98945074.7
(22) Anmeldetag: 30.07.1998
(51) Int. Cl.: H01L 21/762

(54) **ERZEUGNIS UMFASSEND EINE FUNKTIONSSCHICHT ENTHALTEND SILIZIUM UND EINE ISOLIERSCHICHT AUS SILIZIUMDIOXID, SOWIE VERFAHREN ZU SEINER HERSTELLUNG**
PRODUCT COMPRISED OF A SILICON-CONTAINING FUNCTIONAL LAYER AND AN INSULATING LAYER OF SILICON DIOXIDE, AND PRODUCTION
PRODUIT COMPRENANT UNE COUCHE FONCTIONNELLE A TENEUR EN SILICIUM ET UNE COUCHE ISOLANTE EN DIOXYDE DE SILICIUM, ET PROCEDE DE FABRICATION

(30) Priorität: 30.09.1997 DE 19743297
(43) Veröffentlichungstag der Anmeldung: 19.07.2000
(73) Patentinhaber: Infineon Technologies AG, 81669 München (DE)
(72) Erfinder: BIEBL, Markus, D-86163 Augsburg (DE); PINDL, Stephan, D-85238 Petershausen (DE)
(74) Vertreter: Epping Hermann & Fischer
(86) Internationale Anmeldenummer: DE9802181
(87) Internationale Veröffentlichungsnummer: WO99017357

(56) Entgegenhaltungen:
- US-A- 5 362 667
- US-A- 5 468 657
- PATENT ABSTRACTS OF JAPAN vol. 018, no. 199 (E-1534), 7. April 1994 -& JP 06 005586 A (SEIKO EPSON CORP), 14. Januar 1994
- PATENT ABSTRACTS OF JAPAN vol. 012, no. 080 (E-590), 12. März 1988 -& JP 62 219562 A (FUJITSU LTD), 26. September 1987

## Beschreibung

Die Erfindung betrifft ein Erzeugnis umfassend eine Funktionsschicht enthaltend Silizium sowie eine Isolierschicht aus Siliziumdioxid. Die Erfindung betrifft außerdem ein Verfahren zur Herstellung eines solchen Erzeugnisses.

Ein Erzeugnis der eingangs genannten Art ist auf dem Gebiet der Halbleitertechnik bekannt unter der englischen Bezeichnung "Silicon-On-Insulator-Substrate" ( nachfolgend "SOI-Substrat") und hat die in der Einleitung genannte Struktur. In der Regel wird eine solche Struktur aufgebaut auf einer Grundschicht, die ebenfalls aus Silizium besteht.

Ein solches Erzeugnis geht hervor aus US-A-5 468 657, JP-A-06 00 55 86, JP-A-62 219562 und einem Aufsatz von Irita et al, Japanese Journal of Applied Physics 20 (1981)L909. Es wird auch ein Verfahren zur Herstellung eines solchen Erzeugnisses beschrieben. Das Erzeugnis kann mehrere aufeinandergestapelte Anordnungen aus einer Funktionsschicht und einer Isolierschicht enthalten.

Gemäß dem US-Patent 5,468,657 erfolgt eine Implantation von Stickstoff in die Isolierschicht eines Erzeugnisses der eingangs genannten Art, und anschließend erfolgt eine Wärmebehandlung. Dabei wandert der Stickstoff in eine Übergangszone zwischen der Funktionsschicht und der Isolierschicht und dient dort zur Absättigung aufgebrochener chemischer Bindungen. Solche aufgebrochenen chemischen Bindungen können sich ergeben haben bei der Herstellung des Erzeugnisses unter Implantation von Sauerstoff in Silizium. Es werden somit gewisse Bereiche des Erzeugnisses mit Stickstoff dotiert, um diese Bereiche zu passivieren.

Im Rahmen der Technologie der elektronischen Halbleiterbauelemente kann ein Erzeugnis der eingangs genannten Art mit großem Nutzen als Basis für ein elektronisches Halbleiterbauelement dienen. Das Halbleiterbauelement wird dabei gebildet aus entsprechend dotierten Zonen in der Funktionsschicht, und die Isolierschicht findet nützliche Anwendung zur Begrenzung und Isolierung des Bauelements.

Ein Problem, das bei einem Halbleiterbauelement in einem Erzeugnis der eingangs genannten Art auftreten kann, ist die Abwanderung oder Segregation von Dotierstoffen aus der Funktionsschicht in die Isolierschicht durch Diffusion. Diese Diffusion ist besonders stark, wenn das Erzeugnis zur Herstellung des Halbleiterbauelements einer Temperung bei einer erhöhten Temperatur ausgesetzt wird. Ein solcher Verlust an Dotierstoff muß herkömmlicher Praxis durch eine entsprechende Analyse des Herstellprozesses ermittelt und durch entsprechend übermäßige Dotierung der Funktionsschicht ausgeglichen werden.

Ein allein aus Silizium bestehendes Substrat ohne die Isolierschicht aus Siliziumdioxid zeigt die geschilderte Segregation von Dotierstoff nicht. Daher ist es nicht möglich, eine für ein reines Silizium-Substrat gültige Spezifikation für eine Dotierung auf ein Substrat mit einer Funktionsschicht aus Silizium auf einer Isolierschicht aus Siliziumdioxid herkömmlicher Art zu übertragen.

Demzufolge liegt der Erfindung die Aufgabe zugrunde, das Erzeugnis der eingangs genannten Art dahingehend auszubilden, daß die geschilderte Segregation eines Dotierstoffes nicht mehr auftreten kann. Es soll auch ein Verfahren zur Herstellung eines entsprechenden Erzeugnisses angegeben werden.

Zur Lösung dieser Aufgabe angegeben werden ein Erzeugnis und ein Verfahren wie spezifiziert in dem jeweiligen unabhängigen Patentanspruch. Weiterbildungen des Erzeugnisses und des Verfahrens gehen aus entsprechenden abhängigen Patentansprüchen hervor.

Das erfindungsgemäße Erzeugnis umfassend eine Funktionsschicht enthaltend Silizium sowie eine Isolierschicht aus Siliziumdioxid zeichnet sich aus durch eine Stopschicht aus Siliziumnitrid, welche zwischen der Funktionsschicht und der Isolierschicht angeordnet ist und die Funktionsschicht mit der Isolierschicht verbindet, und eine Dicke zwischen 2nm und 4nm hat.

Bei diesem Erzeugnis ist eine spezielle Stopschicht zwischen der Funktionsschicht und der Isolierschicht vorgesehen, welche aus einem Material gebildet ist, in welchem ein herkömmlicher Dotierstoff nicht in wesentlichem Umfange diffundieren kann. Diese Stopschicht wirkt somit als Diffusionsbarriere zwischen der Funktionsschicht und der Isolierschicht und verhindert dementsprechend die Segregation eines Dotierstoffes aus der Funktionsschicht. Damit ist die Stabilität einer dotierten Zone in der Funktionsschicht gewährleistet, und dies aufgrund der entsprechend günstigen Eigenschaften des Siliziumnitrids selbst bei einer erhöhten Temperatur, wie sie im Rahmen eines gemäß herkömmlicher Praxis gelegentlich notwendigen Tempervorganges auftreten kann. Damit ermöglicht die Erfindung auch die Übertragung einer für ein allein aus dem Material der Funktionsschicht bestehendes Substrat gültigen Spezifikation für eine Dotierung auf das entsprechende erfindungsgemäße Erzeugnis.

Es wird davon ausgegangen, daß der gemäß der Erfindung zu verhindernde Effekt der Segregation in erster Linie bedingt ist durch die hohe Diffusionsneigung jedes üblichen Dotierstoffes in Siliziumdioxid. Daher kommt es auf Einzelheiten der Zusammensetzung der Funktionsschicht nicht unbedingt an.

Dessenungeachtet ist eine Weiterbildung der Erfindung gekennzeichnet dadurch, daß die Funktionsschicht im wesentlichen aus Silizium besteht.

Ebenfalls bevorzugt ist es, daß die Stopschicht eine Dicke zwischen 2 nm und 4 nm hat. Die Stopschicht ist damit dünn genug, um die relevanten mechanischen Eigenschaften des Erzeugnisses nicht wesentlich zu beeinflussen und insbesondere keine unerwünschten mechanischen Spannungen in dem Erzeugnis hervorzurufen.

Die Funktionsschicht des Erzeugnisses ist weiterhin bevorzugt im wesentlichen einkristallin und erschließt damit die Anwendung des Erzeugnisses im Rahmen der herkömmlichen Technologie der Halbleiter.

Eine besonders bevorzugte Weiterbildung des Erzeugnisses besteht darin, daß das Erzeugnis zur Bildung dotierter Zonen in der Funktionsschicht eingerichtet ist.

Das erfindungsgemäße Verfahren zur Herstellung eines Erzeugnisses umfassend eine Funktionsschicht enthaltend Silizium und eine Isolierschicht aus Siliziumdioxid sowie eine Stopschicht aus Siliziumnitrid, welche zwischen der Funktionsschicht und der Isolierschicht angeordnet ist und die Funktionsschicht mit der Isolierschicht verbindet, umfaßt folgende Schritte:
- Bereitstellen eines Rohlings umfassend die Funktionsschicht und die Isolierschicht, wobei die Funktionsschicht direkt auf der Isolierschicht angeordnet und mit dieser verbunden ist;
- Implantieren von Stickstoff in die Isolierschicht; und
- Tempern des Rohlings mit dem implantierten Stickstoff zur Bewirkung einer Diffusion des Stickstoffs zur Funktionsschicht und Verbindung des Stickstoffs mit Silizium aus der Funktionsschicht zur Bildung der Stopschicht.
wobei der Stickstoff mit einer solchen Dosis in die Isolierschicht implantiert wird, daß beim Tempern die Stopschicht mit einer Dicke zwischen 2 nm und 4 nm entstehen kann. Dies gewährleistet, daß die Stopschicht die gewünschte Wirkung als Diffusionsbarriere in vollem Umfange entfalten kann.

Das Verfahren geht somit aus von einem Rohling nach Art eines herkömmlichen SOI-Substrates, bei dem die Funktionsschicht direkt mit der Isolierschicht verbunden ist. Zwischen der Funktionsschicht und der Isolierschicht wird die Stopschicht nachträglich erzeugt, indem Stickstoff in die Funktionsschicht implantiert, durch Diffusion zur Funktionsschicht gebracht und mit Silizium aus dieser zur Bildung der Stopschicht verbunden wird. Die Stopschicht entsteht gewissermaßen von selbst mit einer nur geringen Dicke, da die Verbindung des Siliziums mit dem Stickstoff unter Bildung des gewünschten Siliziumnitrids im Rahmen eines chemischen Prozesses erfolgt, welcher selbstregulierend ist. Dieser chemische Prozeß ist auch nicht besonders abhängig von der beim Tempern eingestellten Temperatur und somit hinreichend stabil bei serienweiser Wiederholung. Die Temperung im Rahmen des Verfahrens trägt auch wesentlich bei zur Beseitigung von Schäden in der Funktionsschicht, die sich bei der Implantation womöglich eingestellt haben.

Das Verfahren erfordert nicht notwendigerweise eine aus reinem Silizium bestehende Funktionsschicht; lediglich muß die Funktionsschicht eine ausreichende Menge von Silizium zur Bildung der Stopschicht bereitstellen können.

Auf die geometrischen Parameter der Funktionsschicht kommt es erfindungsgemäß nicht grundsätzlich an. Soll die Implantation des Stickstoffs in die Isolierschicht allerdings durch die Funktionsschicht hindurch erfolgen, so ist es unter Umständen von Vorteil, die Dicke der Funktionsschicht auf ein angemessenes Maß zu begrenzen. Dies kann erfordern, daß eine ursprünglich vorhandene Funktionsschicht vor der Implantation des Stickstoffes teilweise abgetragen und nach erfolgter Implantation erneut durch ein geeignetes Verfahren der Epitaxie aufgewachsen wird. Gegebenenfalls kann auch ein Rohling mit ausreichend dünner Funktionsschicht bereitgestellt und nach erfolgter Implantation durch Epitaxie mit einer gemäß Vorgabe dicken Funktionsschicht versehen werden. In jedem Falle trägt die Begrenzung der Strecke, die der implantierte Stickstoff in dem Erzeugnis durchqueren muß, bei zur Gewährleistung einer nicht allzu breiten Verteilung des implantierten Stickstoffes in der Isolierschicht und anderen Bereichen des Erzeugnisses. Daher ist es bevorzugt, die Implantation des Stickstoffes durch die (hinreichend dünne) Funktionsschicht hindurch durchzuführen.

Eine bevorzugte Weiterbildung des Verfahrens ist dadurch gekennzeichnet, daß der Stickstoff derart implantiert wird, daß eine Verteilung des Stickstoffs in der Isolierschicht bei einer Distanz von der Funktionsschicht zwischen 10 nm und 20 nm ein Maximum erreicht. Dies erfordert eine sorgfältige Anpassung der kinetischen Energie, mit welcher die Atome oder Ionen des zu implantierenden Stickstoffes in den Rohling eindringen.

Eine bevorzugte Weiterbildung des Verfahrens erfordert, daß in der Funktionsschicht nach dem Implantieren des Stickstoffs dotierte Zonen gebildet werden. Dies erschließt das Verfahren der Anwendung im Rahmen der Technologie der elektronischen Halbleiterbauelemente.

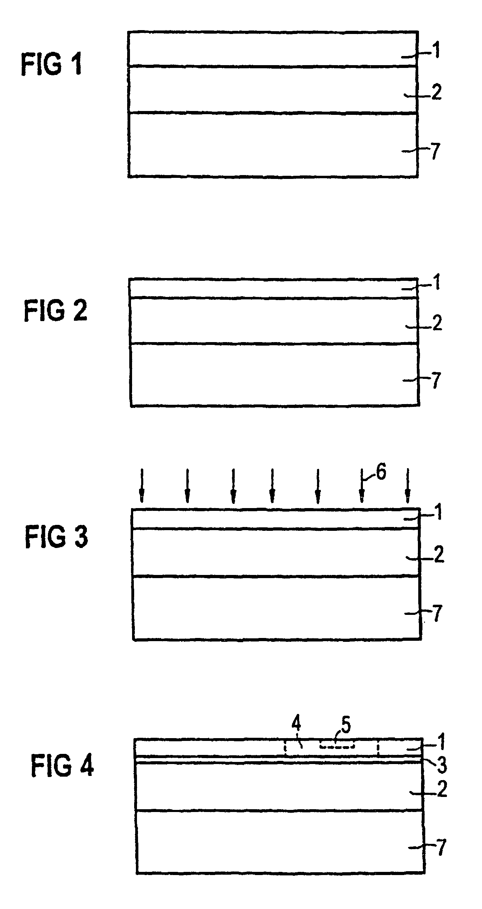

Ausführungsbeispiele des Erzeugnisses und des Verfahrens werden nachfolgend anhand der Zeichnung erläutert. Die Zeichnung zeigt skizzenhaft die Entstehung eines Erzeugnisses im Sinne der Erfindung aus einem herkömmlichen SOI-Substrat anhand der Figuren 1 bis 4. Die Zeichnung ist zur Herausstellung bestimmter Merkmale nicht maßstäblich.

Figur 1 zeigt ein herkömmliches SOI-Substrat mit einer aus Silizium bestehenden Funktionsschicht 1, direkt verbunden mit einer aus Siliziumdioxid bestehenden Isolierschicht 2, diese direkt verbunden mit einer wiederum aus Silizium bestehenden Grundschicht 7. Je nachdem kann auch die Grundschicht 7 als weitere Funktionsschicht genutzt werden entsprechend den Anforderungen des jeweiligen Einzelfalls der Verwendung. Wie ausgeführt kann es von Vorteil sein, die Funktionsschicht 1 vor den weiteren Schritten des Verfahrens zu verdünnen, vergleiche Figur 2 mit Figur 1. Falls erforderlich, kann die Funktionsschicht 1 nach Abschluß der nachfolgend zu erläuternden Verfahrensschritte durch epitaktisches Aufwachsen auf eine gewünschte Dicke gebracht werden.

Zur Bildung einer Diffusionsbarriere zwischen der Funktionsschicht 1 und der Isolierschicht 2 wird nun Stickstoff 6 durch die Funktionsschicht 1 hindurch in die Isolierschicht 2 implantiert; dabei werden die vorstehend als bevorzugt spezifizierten Kriterien eingehalten. Anschließend erfolgt eine Temperung des implantierten Rohlings, damit der in die Isolierschicht 2 implantierte Stickstoff in hinreichend hohem Maße diffundiert und so zur Funktionsschicht 1 gelangt, wo er sich mit Silizium verbinden kann unter Bildung von Siliziumnitrid, welches sich, siehe Figur 4, als Stopschicht 3 zwischen die Funktionsschicht 1 und die Isolierschicht 2 lagert. Die Stopschicht 3 erfüllt wiederum die vorstehend als bevorzugt spezifizierten Kriterien. Das somit komplettierte Erzeugnis zeichnet sich aus durch besondere Eignung für die Herstellung eines elektronischen Bauelementes in der Funktionsschicht 1. Ein solches Bauelement ist gekennzeichnet durch dotierte Zonen 4 und 5, welche sich ganz (Bezugszeichen 4) oder teilweise (Bezugszeichen 5) durch die Funktionsschicht 1 erstrecken können und hinsichtlich der Auswahl des jeweils zur Dotierung benutzten Dotierstoffes den Erfordernissen des herzustellenden elektronischen Halbleiterbauelementes entsprechen. Die Bevorzugung des die Stopschicht 3 aufweisenden Erzeugnisses erklärt sich daraus, daß die Stopschicht 3 eine Abwanderung oder Segregation von Dotierstoffen aus den dotierten Zonen 4 und 5 in die Isolierschicht 2 wirksam verhindert und somit eine langfristige Stabilität des die dotierten Zonen 4 und 5 umfassenden elektronischen Bauelements gewährleistet.

## Patentansprüche

1. Erzeugnis umfassend eine Funktionsschicht (1) enthaltend Silizium sowie eine Isolierschicht (2) aus Siliziumdioxid, wobei eine Stopschicht (3) aus Siliziumnitrid, welche zwischen der Funktionsschicht (1) und der Isolierschicht (2) angeordnet ist, die Funktionsschicht (1) mit der Isolierschicht (2) verbindet **dadurch gekennzeichnet, daß** die Stopschicht (3), eine Dicke zwischen 2 nm und 4 nm hat.

2. Erzeugnis nach Anspruch 1,
bei dem die Funktionsschicht (1) im wesentlichen aus Silizium besteht.

3. Erzeugnis nach einem der vorhergehenden Ansprüche,
bei dem die Funktionsschicht (1) im wesentlichen einkristallin ist.

4. Erzeugnis nach einem der vorhergehenden Ansprüche,
welches eingerichtet ist zur Bildung dotierter Zonen (4, 5) in der Funktionsschicht (1).

5. Verfahren zur Herstellung eines Erzeugnisses umfassend eine Funktionsschicht (1) enthaltend Silizium und eine Isolierschicht (2) aus Siliziumdioxid sowie eine Stopschicht (3) aus Siliziumnitrid, welche zwischen der Funktionsschicht (1) und der Isolierschicht (2) angeordnet ist und die Funktionsschicht (1) mit der Isolierschicht (2) verbindet, welches Verfahren folgende Schritte umfaßt:
- Bereitstellen eines Rohlings umfassend die Funktionsschicht (1) und die Isolierschicht (2), wobei die Funktionsschicht (1) direkt auf der Isolierschicht (2) angeordnet und mit dieser verbunden ist;
- Implantieren von Stickstoff (6) in die Isolierschicht (2); und
- Tempern des Rohlings mit dem implantierten Stickstoff (6) zur Bewirkung einer Diffusion des Stickstoffs (6) zur Funktionsschicht (1) und Verbindung des Stickstoffs (6) mit Silizium aus der Funktionsschicht (1) zur Bildung der Stopschicht (3),
wobei der Stickstoff (6) mit einer solchen Dosis in die Isolierschicht (2) implantiert wird, daß beim Tempern die Stopschicht (3) mit einer Dicke zwischen 2 nm und 4 nm entstehen kann.

6. Verfahren nach Anspruch 5,
bei dem der Stickstoff (6) durch die Funktionsschicht (1) hindurch implantiert wird.

7. Verfahren nach einem der Ansprüche 5 und 6,
bei dem der Stickstoff (6) derart implantiert wird, daß eine Verteilung des Stickstoffs (6) in der Isolierschicht (2) bei einer Distanz von der Funktionsschicht (1) zwischen 10 nm und 20 nm ein Maximum erreicht.

8. Verfahren nach einem der Ansprüche 5 bis 7,
bei dem die Funktionsschicht (1) nach dem Implantieren des Stickstoffs (6) durch epitaktisches Aufwachsen verdickt wird.

9. Verfahren nach einem der Ansprüche 5 bis 8,
bei dem in der Funktionsschicht (1) nach dem Implantieren des Stickstoffs (6) dotierte Zonen (4, 5) gebildet werden.

## Claims

1. Product comprising a silicon-containing functional layer (1) and an insulating layer (2) made of silicon dioxide, wherein a stop layer (3) made of silicon nitride, which is arranged between the functional layer (1) and the insulating layer (2), bonds the functional layer (1) to the insulating layer (2), **characterized in that** the stop layer (3) has a thickness of between 2nm and 4nm.

2. Product according to Claim 1, in which the functional layer (1) is essentially composed of silicon.

3. Product according to one of the preceding claims, in which the functional layer (1) is essentially monocrystalline.

4. Product according to one of the preceding claims, which is set up for the formation of doped zones (4, 5) in the functional layer (1).

5. Method for fabricating a product comprising a silicon-containing functional layer (1) and an insulating layer (2) made of silicon dioxide and a stop layer (3) made of silicon nitride which is arranged between the functional layer (1) and the insulating layer (2) and bonds the functional layer (1) to the insulating layer (2), which method comprises the following steps:
- provision of a blank comprising the functional layer (1) and the insulating layer (2), the functional layer (1) being arranged directly on the insulating layer (2) and being bonded thereto;
- implantation of nitrogen (6) into the insulating layer (2); and
- heat treatment of the blank with the implanted nitrogen (6) in order to effect diffusion of the nitrogen (6) to the functional layer (1) and bonding of the nitrogen (6) to silicon of the functional layer (1) for forming the stop layer (3), the nitrogen (6) being implanted into the insulating layer (2) with a dose such that the stop layer (3) can be formed with a thickness of between 2 nm and 4 nm in the course of the heat treatment.

6. Method according to Claim 5, in which the nitrogen (6) is implanted through the functional layer (1).

7. Method according to either of Claims 5 and 6,
in which the nitrogen (6) is implanted in such a way that a distribution of the nitrogen (6) in the insulating layer (2) reaches a maximum at a distance from the functional layer (1) of between 10 nm and 20 nm.

8. Method according to one of Claims 5 to 7,
in which the functional layer (1) is thickened by epitaxial growth after the implantation of the nitrogen (6).

9. Method according to one of Claims 5 to 8,
in which doped zones (4, 5) are formed in the functional layer (1) after the implantation of the nitrogen (6).

## Revendications

1. Produit comprenant une couche (1) fonctionnelle contenant du silicium ainsi qu'une couche (2) isolante en dioxyde de silicium, une couche (3) d'arrêt en nitrure de silicium qui est interposée entre la couche (1) fonctionnelle et la couche (2) isolante reliant la couche (1) fonctionnelle à la couche (2) isolante, **caractérisé en ce que** la couche (3) d'arrêt a une épaisseur comprise entre 2 nm et 4 nm.

2. Produit suivant la revendication 1, dans lequel la couche (1) fonctionnelle est essentiellement en silicium.

3. Produit suivant l'une des revendications précédentes, dans lequel la couche (1) fonctionnelle est essentiellement monocristalline.

4. Produit suivant l'une des revendications précédentes, qui est disposé pour former des zones (4, 5) dopées dans la couche (1) fonctionnelle.

5. Procédé de fabrication d'un produit comprenant une couche (1) fonctionnelle contenant du silicium et une couche (2) isolante en dioxyde de silicium, ainsi qu'une couche (3) d'arrêt en nitrure de silicium qui est interposée entre la couche (1) fonctionnelle et la couche (2) isolante et qui relie la couche (1) fonctionnelle à la couche (2) isolante, ce procédé comprenant les stades suivants :
- mise à disposition d'une ébauche comprenant la couche (1) fonctionnelle et la couche (2) isolante, la couche (1) fonctionnelle étant disposée directement sur la couche (2) isolante et reliée à celle-ci ;
- implantation d'azote (6) dans la couche (2) isolante ; et
- recuit de l'ébauche ayant l'azote (6) implanté pour provoquer une diffusion de l'azote (6) vers la couche (1) fonctionnelle et la liaison de l'azote (6) au silicium de la couche (1) fonctionnelle pour former la couche (3) d'arrêt,
l'azote (6) étant implanté en une dose telle dans la couche (2) isolante que, lors du recuit, la couche (3) d'arrêt peut se former en une épaisseur comprise entre 2 nm et 4 nm.

6. Procédé suivant la revendication 5, dans lequel on implante l'azote (6) à travers la couche (1) fonctionnelle.

7. Procédé suivant l'une des revendications 5 et 6, dans lequel on implante l'azote (6) de façon à ce qu'une répartition de l'azote (6) dans la couche (2) isolante atteigne un maximum à une distance de la couche (1) fonctionnelle comprise entre 10 nm et 20 nm.

8. Procédé suivant l'une des revendications 5 à 7, dans lequel on épaissit par croissance épitaxiale la couche (1) fonctionnelle après l'implantation de l'azote (6).

9. Procédé suivant l'une des revendications 5 à 8, dans lequel on forme dans la couche (1) fonctionnelle des zones (4, 5) dopées après l'implantation de l'azote (6).
